Europäisches Patentamt

European Patent Office

Office européen des brevets

(19)

(11) **EP 1 214 780 B1**

(12) ## FASCICULE DE BREVET EUROPEEN

(45) Date de publication et mention
de la délivrance du brevet:
**14.05.2003 Bulletin 2003/20**

(21) Numéro de dépôt: **00964349.5**

(22) Date de dépôt: **22.09.2000**

(51) Int Cl.⁷: **H03F 1/02**, H04B 1/04

(86) Numéro de dépôt international:
**PCT/FR00/02628**

(87) Numéro de publication internationale:
**WO 01/022572 (29.03.2001 Gazette 2001/13)**

(54) **EMETTEUR DE SIGNAUX RADIOELECTRIQUES MODULES A POLARISATION D'AMPLIFICATION AUTO-ADAPTEE**

SENDER FÜR FUNKSIGNALE, DIE MIT EINER AUTOADAPTIVEN VERSTÄRKERSPOLARISATION MODULIERT WERDEN

MODULATED RADIO SIGNAL TRANSMITTER WITH SELF-ADAPTED AMPLIFICATION POLARISATION

(84) Etats contractants désignés:
**AT BE CH CY DE DK ES FI FR GB GR IE IT LI LU MC NL PT SE**

(30) Priorité: **24.09.1999 FR 9911943**

(43) Date de publication de la demande:
**19.06.2002 Bulletin 2002/25**

(73) Titulaire: **CENTRE NATIONAL D'ETUDES SPATIALES (C.N.E.S.)
Etablissement public, scientifique et
F-75039 Paris Cédex 01 (FR)**

(72) Inventeur: **LAPIERRE, Luc
F-31500 Toulouse (FR)**

(74) Mandataire:
**Cabinet BARRE LAFORGUE & associés
95, rue des Amidonniers
31000 Toulouse (FR)**

(56) Documents cités:
**EP-A- 0 382 697        US-A- 5 745 526
US-A- 5 933 767**

## Description

L'invention concerne un émetteur de signaux radioélectriques, dits signaux modulés de sortie, modulés au moins en amplitude selon une pluralité discrète de niveaux d'amplitude distincts prédéterminés à partir de signaux de commande numériques comprenant :

- des moyens de modulation adaptés pour convertir les signaux de commande numériques en signaux modulés, dits signaux modulés d'entrée,
- des moyens d'amplification de puissance à état solide comportant au moins un transistor de puissance, dont au moins un transistor de puissance de sortie délivrant des signaux modulés de sortie,
- des moyens de polarisation comportant au moins une source de tension, et adaptés pour polariser chaque transistor de puissance des moyens d'amplification.

Les émetteurs de signaux radioélectriques modulés sont connus de longue date et peuvent être extrêmement variés. La modulation peut être une modulation en phase et/ou en amplitude et/ou en fréquence. Dans le cas de la modulation d'amplitude, et aussi dans le cas de certaines modulations de phase, les signaux modulés reçus à l'entrée et ceux délivrés en sortie des moyens d'amplification de puissance présentent une amplitude qui varie en permanence de façon discrète, c'est-à-dire en pouvant prendre l'une des valeurs d'une pluralité discrète prédéterminée de niveaux d'amplitude distincts.

De ce fait, on est obligé de surdimensionner les moyens d'amplification et de polariser les transistors de puissance avec un fort recul d'entrée pour éviter la saturation et permettre de délivrer les différentes puissances de sortie avec une bonne linéarité. Mais, il s'avère que le rendement d'un transistor de puissance varie, pour une polarisation donnée, comme l'amplitude des signaux à l'entrée et à la sortie du transistor. Dès lors, pour les niveaux d'amplitude des signaux les plus faibles, le rendement du transistor chute considérablement. Or, une telle chute de rendement est fortement préjudiciable dans toutes les applications où la source d'énergie électrique d'alimentation de l'émetteur n'est pas inépuisable, notamment est formée d'accumulateurs ou de piles, et plus généralement lorsque cette énergie électrique est coûteuse.

Dans ces applications, on renonce donc jusqu'à maintenant à utiliser une modulation telle que la modulation d'amplitude M-QAM à M états malgré les avantages importants qu'une telle modulation peut procurer (notamment un faible encombrement spectral pour un même rythme de bits). Tel est en particulier le cas à bord des systèmes spatiaux tels que les satellites, et plus particulièrement les microsatellites, dans lesquels les économies d'énergie et de coût ainsi que le problème de simplicité et de rapidité de fabrication sont cruciaux. Tel est aussi le cas des équipements de radiocommunication portables.

Ce problème se pose de façon générale pour chacun des transistors de puissance des moyens d'amplification, mais plus particulièrement au moins pour le (les) transistor(s) de puissance de sortie dont le fonctionnement détermine en grande partie la consommation électrique globale de l'émetteur. On sait en effet que, dans le cas de plusieurs étages d'amplification, la consommation électrique est la plus importante dans l'étage de sortie délivrant les signaux de sortie.

Pour remédier à ce problème, il a été proposé une technique dite d'élimination/restauration d'enveloppe EER dans laquelle on détecte l'enveloppe des signaux modulés issus du modulateur, on élimine l'enveloppe des signaux modulés à l'aide d'un limiteur d'amplitude, on sature le transistor de puissance de sortie avec une forte puissance d'entrée, on utilise pour la polarisation un convertisseur à découpage PWM ("pulse width modulation") à haute fréquence (la fréquence de découpage devant être très supérieure à celle de l'enveloppe des signaux modulés) que l'on pilote selon l'enveloppe préalablement détectée, de sorte que la variation de la polarisation fournie par ce convertisseur permet de restaurer l'enveloppe sur les signaux modulés à la sortie du transistor de puissance de sortie. Cette technique est cependant limitée par les valeurs de fréquence de découpage et n'est donc pas aisément applicable aux très hautes fréquences d'enveloppe, notamment dans le domaine des transmissions de données numériques à haut débit (typiquement de plusieurs mégabits par seconde ou dizaines de mégabits par seconde entre les systèmes spatiaux -notamment les satellites- et la Terre). En outre, la réalisation du détecteur d'enveloppe, du limiteur, et du convertisseur, est relativement complexe -notamment dans le domaine des transmissions à haut débit où les signaux modulés ont une porteuse hyperfréquence-.

En particulier, il est à noter que lorsque l'enveloppe complexe d'un signal hyperfréquence passe de part et d'autre de la valeur 0, l'enveloppe du signal réel présente un point de rebroussement, ce qui induit, avec cette technique EER, une brusque variation de tension, avec des composantes spectrales dont les fréquences sont extrêmement élevées. De surcroît, cette technique EER nécessite une excellente linéarité globale du système formé par les moyens d'amplification et par le convertisseur de polarisation, sur toute la dynamique de l'enveloppe du signal.

De façon similaire, le document "MICROWAVE POWER AMPLIFIER EFFICIENCY IMPROVEMENT WITH A 10MHz HBT DC-DC CONVERTER" Gary Hanington et *al,* International Microwave Symposium, Baltimore, 1998 IEEE MTT-S Digest WE2C-6 p. 589-592, enseigne de détecter la puissance du signal modulé d'entrée de l'amplificateur avec un coupleur RF et un détecteur d'enveloppe, et de piloter la valeur de la tension de polarisation de l'étage d'amplification de puissance fournie par un convertisseur à découpage PWM. Là encore, cette solution est limitée en fréquence (les signaux modulés pouvant avoir un spectre de variation ne dépassant pas 2 MHz pour une fréquence de découpage entre 10 et 20 MHz). De surcroît, sa réalisation est relativement complexe, notamment lorsque les signaux modulés ont une porteuse hyperfréquence. On sait en effet que les circuits traversés par des signaux hyperfréquences sont complexes, coûteux et délicats à mettre au point. De surcroît, il est à noter que toute erreur ou tout bruit incorporé dans les signaux modulés d'entrée est répercutée sur le convertisseur et sur la polarisation du transistor de puissance. Dès lors, cette solution tend à amplifier les erreurs et bruits et présente un fonctionnement peu précis.

L'invention vise donc à pallier l'ensemble de ces inconvénients et à proposer un émetteur tel que mentionné et dans lequel au moins le(les) transistor(s) de puissance de sortie -notamment tous les transistors de puissance- présente(nt) un rendement qui reste optimisé, c'est-à-dire est en permanence le meilleur possible, y compris pour les faibles niveaux d'amplitude des signaux d'entrée, et qui de surcroît soit simple et peu coûteux à réaliser et aisément applicable dans tous les domaines de fréquence de porteuse des signaux -y compris dans le domaine des hyperfréquences- et dans tous les domaines de fréquence de variation des signaux -y compris pour les transmissions à haut débit-.

L'invention vise ainsi à permettre la mise en oeuvre d'une modulation telle qu'une modulation d'amplitude de type M-QAM en quadrature à M états, M étant une puissance de 2, générant des signaux modulés à l'entrée des moyens d'amplification dont l'amplitude varie selon une pluralité discrète de niveaux d'amplitude, sans grever sensiblement la consommation électrique de l'émetteur comparativement aux autres types de modulation dans lesquels l'amplitude des signaux modulés d'entrée reste au moins sensiblement constante, et ce de façon simple, économique et applicable à tous les domaines de fréquence, y compris les porteuses hyperfréquences et/ou les transmissions à haut débit.

L'invention vise en particulier à proposer un tel émetteur qui ne nécessite pas l'emploi d'un convertisseur à découpage PWM à haute fréquence de découpage, et qui n'impose en fait aucune contrainte particulière sur la fréquence ou la technique de découpage, ni même l'emploi d'une telle technique, pour assurer la polarisation des transistors de puissance.

L'invention vise aussi à proposer un tel émetteur dans lequel le nombre de circuits traversés par les signaux modulés, et qui doivent transmettre la porteuse ou être compatibles avec sa fréquence, est aussi faible que possible. En particulier, l'invention vise à minimiser le nombre de circuits hyperfréquences de l'émetteur.

L'invention vise aussi à proposer un tel émetteur dont le fonctionnement est fiable et précis, c'est-à-dire fournissant un signal modulé de sortie de niveau d'amplitude exempt d'erreur.

L'invention vise aussi à proposer un tel émetteur qui soit en particulier adapté aux transmissions spatiales et qui peut être avantageusement intégré à bord d'un engin spatial tel qu'un satellite artificiel -notamment un microsatellite terrestre- de façon simple et économique.

Pour ce faire, l'invention concerne un émetteur tel que mentionné ci-dessus, et qui est caractérisé en ce que les moyens de polarisation sont adaptés pour pouvoir délivrer, pour au moins une borne à polariser de chaque transistor de puissance de sortie des moyens d'amplification, une pluralité discrète prédéterminée de niveaux de tension de polarisation distincts, chaque niveau de tension de polarisation étant associé et adapté à l'un au moins desdits niveaux d'amplitude des signaux modulés de sortie,
et en ce qu'il comprend :

- des moyens, dits moyens d'analyse, adaptés pour élaborer en temps réel à partir de la valeur instantanée des signaux de commande numériques, un signal, dit signal de sélection, dont la valeur instantanée est représentative du niveau d'amplitude instantané devant être pris par les signaux modulés de sortie à émettre correspondant à cette valeur instantanée des signaux de commande numériques, la valeur instantanée du signal de sélection variant avec les signaux de commande numériques selon une pluralité discrète de valeurs correspondant aux différents niveaux d'amplitude des signaux modulés de sortie,
- des moyens de commutation recevant le signal de sélection et adaptés pour sélectionner et appliquer à chaque instant, sur ladite borne à polariser, une tension de polarisation délivrée par les moyens de polarisation dont la valeur est égale au niveau de tension de polarisation associé et adapté au niveau d'amplitude représenté par la valeur instantanée du signal de sélection.

Ainsi, l'émetteur selon l'invention peut être réalisé de façon extrêmement simple et économique, et ne nécessite en particulier aucun convertisseur complexe et performant pour la polarisation des transistors de puissance. L'émetteur selon l'invention ne nécessite en outre aucun circuit supplémentaire traversé par la porteuse, ou compatible avec la fréquence de la porteuse -notamment aucun circuit hyperfréquence lorsque le signal de porteuse est dans le domaine des hyperfréquences-. L'émetteur selon l'invention ne comporte en effet que des moyens d'analyse des signaux de commande numériques, et des moyens de commutation, pilotés au rythme des variations d'amplitude des signaux modulés de sortie.

Il est à noter en particulier que la détection effectuée pour adapter en temps réel la tension de polarisation de chaque transistor de puissance de sortie n'intervient pas sur des signaux analogiques ou au niveau de la modulation connue dans l'art antérieur, ce qui nécessitait une détection d'enveloppe relativement complexe. Cette détection est au contraire réalisée par les moyens d'analyse à partir de la valeur numérique instantanée des signaux de commande numériques (bande de base), par une détermination -notamment par un circuit logique- du niveau d'amplitude que les signaux modulés de sortie doivent présenter pour coder cette valeur numérique, selon la modulation réalisée par l'émetteur, dont on connaît par ailleurs les caractéristiques et la logique. Ainsi, bien que la valeur instantanée du niveau d'amplitude soit déjà déterminée par la chaîne d'émission (modulation et conversion numérique/ analogique, et amplification de puissance), l'invention n'utilise pas cette détermination (contrairement à la technique EER et au document suscité) pour élaborer le signal de sélection, mais utilise des moyens d'analyse spécifiques complémentaires qui déterminent et/ou calculent en parallèle de façon logique à partir des signaux de commande numériques (bande de base) le niveau d'amplitude correspondant à ces signaux de commande numériques.

Les moyens de polarisation, les moyens d'analyse, et les moyens de commutation réalisent des moyens d'adaptation en temps réel de la tension de polarisation délivrée par les moyens de polarisation pour au moins une borne de chaque transistor de puissance de sortie des moyens d'amplification de puissance, selon la valeur instantanée devant être prise par les signaux modulés de sortie. Et cette adaptation est effectuée non pas à partir de l'enveloppe de signaux modulés issus d'un circuit de modulation, mais à partir des signaux numériques de commande (bande de base) à émettre. On obtient ainsi une adaptation beaucoup plus précise et fiable, sans circuit à haute fréquence supplémentaire, et avec des moyens de polarisation simples et fiables.

La polarisation des moyens d'amplification étant pilotée à partir des signaux numériques, les erreurs ou bruits dus à la modulation ne sont pas répercutés sur le fonctionnement des transistors de puissance, qui est plus fiable et précis.

De surcroît, dans un émetteur selon l'invention, les moyens de polarisation délivrant une pluralité discrète de niveaux de tension (c'est-à-dire un nombre entier supérieur à 1 de niveaux de tension) sont plus simples, plus économiques et plus fiables que dans l'art antérieur où il était nécessaire d'utiliser un convertisseur PWM dont la fréquence de découpage et les propriétés devaient être adaptées pour permettre de fournir une tension pouvant être continûment variable. Il est en effet à noter que la fréquence de découpage, les caractéristiques et les performances des moyens de polarisation qui fournissent des niveaux de tension toujours identiques, ne sont en aucune manière affectées par les variations d'amplitude des signaux modulés. Ainsi, si l'invention implique une certaine redondance de détermination des niveaux d'amplitude de modulation, cette redondance ne rend pas l'émetteur plus complexe et induit en fait, au contraire, une grande simplification et des performances accrues, y compris dans le domaine des hyperfréquences.

Avantageusement et selon l'invention, les moyens d'analyse sont formés d'un circuit électronique logique adapté pour déterminer, à partir de la valeur numérique instantanée des signaux de commande numériques, ledit niveau d'amplitude instantané et pour élaborer le signal de sélection représentatif de ce niveau d'amplitude instantané. Le circuit logique est adapté, selon la modulation utilisée, pour déterminer le niveau d'amplitude des signaux modulés de sortie correspondant à chaque train de bits des signaux de commande numériques. Il s'agit donc d'une logique combinatoire simple et fiable, dont les résultats ne dépendent pas des erreurs et bruits des circuits analogiques ou des circuits hyperfréquences.

Avantageusement, l'invention concerne un émetteur tel que mentionné ci-dessus comprenant un circuit de modulation adapté pour convertir les signaux de commande numériques en signaux analogiques modulés, au moins en amplitude, selon une pluralité discrète de niveaux d'amplitude distincts prédéterminés, caractérisé en ce que les moyens d'analyse sont adaptés pour élaborer et délivrer, à partir des signaux de commande numériques, un signal de sélection dont la valeur instantanée est représentative du niveau d'amplitude instantané des signaux délivrés par le circuit de modulation.

En particulier, la modulation d'amplitude peut être avantageusement réalisée par un circuit spécifique distinct des moyens d'amplification de puissance et des moyens de polarisation.

En variante, la modulation d'amplitude peut être réalisée, partiellement ou entièrement, par les transistors d'amplification de puissance, grâce aux variations des tensions de polarisation. Dans ce cas, le circuit de modulation peut n'effectuer qu'une modulation de phase (dite "PSK"). L'influence des moyens d'amplification dans la modulation d'amplitude dépend du montage des transistors de puissance, de la classe de fonctionnement, et de la façon dont leurs différentes bornes sont polarisées à partir des moyens de polarisation.

Par exemple, pour éviter tout effet des variations de polarisation des transistors de puissance sur l'amplitude des signaux modulés de sortie, on fait varier, à l'aide des moyens de commutation, simultanément les tensions de polarisation de deux bornes de chaque transistor (par exemple la tension de polarisation du drain et la tension de polarisation de la grille pour un transistor à effet de champ en source commune). Cette double variation peut être obtenue au moins en partie par un choix approprié de la classe de fonctionnement du transistor, par exemple en classe B pour un transistor à effet de champ. A l'inverse si seule une borne voit sa tension de polarisation qui varie, le transistor de puissance entraînera le plus souvent (sauf en classe B) une modulation d'amplitude des signaux modulés de sortie.

Avantageusement et selon l'invention, les moyens de modulation sont des moyens de modulation d'amplitude M-QAM en quadrature à M états, M étant une puissance de 2. Il est à noter que le nombre de niveaux d'amplitude n'est pas égal au nombre d'états de modulation adressés dans le plan complexe. Par exemple, pour une modulation 16-QAM, les signaux modulés n'ont que trois niveaux d'amplitude.

Avantageusement et selon l'invention, ladite pluralité discrète de niveaux de tension de polarisation comprend un nombre entier N>1 de niveaux de tension de polarisation égal au nombre de niveaux d'amplitude de ladite pluralité discrète de niveaux d'amplitude des signaux modulés de sortie, chaque niveau de tension de polarisation étant associé et adapté à un et un seul niveau d'amplitude. En variante, un même niveau de tension de polarisation peut être associé et adapté à plusieurs niveaux d'amplitude, par exemple si les niveaux d'amplitude peuvent être groupés en plusieurs groupes de niveaux voisins.

Avantageusement et selon l'invention, chaque niveau de tension de polarisation est adapté pour que le rendement de chaque transistor de puissance de sortie polarisé avec ce niveau de tension de polarisation soit optimum pour le niveau d'amplitude des signaux modulés de sortie SMS qu'il délivre. Plus particulièrement, avantageusement et selon l'invention, chaque niveau de tension de polarisation est adapté pour que chaque transistor de puissance de sortie polarisé avec ce niveau de tension de polarisation délivre une puissance de sortie qui est de l'ordre de sa puissance de début de saturation pour le niveau d'amplitude des signaux modulés de sortie qu'il délivre. Un émetteur selon l'invention est avantageusement caractérisé en ce que chaque transistor de puissance de sortie des moyens d'amplification est un transistor à effet de champ recevant des signaux modulés d'entrée sur sa grille et délivrant les signaux modulés de sortie sur son drain, en ce que les moyens de polarisation sont adaptés pour pouvoir délivrer une pluralité discrète de niveaux de tension VD de polarisation du drain, et en ce que les moyens de commutation sont adaptés pour piloter la valeur de la tension VD de polarisation du drain de chaque transistor de puissance de sortie selon la valeur du signal de sélection.

En outre, avantageusement et selon l'invention, les moyens de polarisation sont aussi adaptés pour pouvoir délivrer une pluralité discrète de niveaux de tension VG de polarisation de la grille, et en ce que les moyens de commutation sont adaptés pour piloter la valeur de la tension VG de polarisation de la grille de chaque transistor de puissance de sortie selon la valeur du signal de sélection. De la sorte, le gain du transistor en amplitude peut être maintenu au moins sensiblement constant malgré les variations de tension de polarisation du drain. En effet, on sait que la tension de polarisation de la grille VG permet de piloter l'intensité moyenne du courant dans le drain. En variante, le même effet peut être obtenu au moins en partie automatiquement à partir des signaux modulés d'entrée, si le transistor de puissance est placé dans une classe de fonctionnement qui permet une telle auto-adaptation du gain, par exemple en classe B. En tout état de cause, l'invention permet d'obtenir une variation de la tension de polarisation du drain et de l'intensité moyenne dans le drain permettant d'obtenir le rendement optimum pour chaque niveau d'amplitude, y compris les niveaux les plus faibles.

Dans le cas où les moyens d'amplification comprennent plusieurs transistors de puissance, avantageusement et selon l'invention, les moyens de commutation sont adaptés pour piloter la valeur de tension de polarisation d'au moins une borne de nature prédéterminée (identique pour tous les transistors montés de façon semblable) de chaque transistor selon la valeur du signal de sélection. Par exemple, on pilote la tension de polarisation de drain de tous les transistors montés en source commune.

De même, si les moyens d'amplification comportent plusieurs étages, avantageusement et selon l'invention, chaque transistor de puissance de chaque étage est piloté par le signal de sélection. Mais on sait que le rendement de l'émetteur dépend surtout de celui de l'étage de sortie. En variante selon l'invention, on peut donc aussi prévoir que les moyens de commutation sont adaptés pour ne piloter que chaque transistor de puissance de l'étage de sortie des moyens d'amplification.

Un tel émetteur peut trouver de nombreuses applications et être adapté à de nombreuses gammes de fréquences. Il peut néanmoins avantageusement être adapté pour l'émission de signaux avec une porteuse dans le domaine des hyperfréquences, et aptes à transmettre des données numériques avec un débit compris entre 1 Mbits/s et 100 Mbits/s.

L'invention concerne aussi un émetteur caractérisé en combinaison pour tout ou partie des caractéristiques mentionnées ci-dessus ou ci-après.

D'autres buts, caractéristiques et avantages de l'invention apparaissent de la description suivante qui se réfère aux figures annexées illustrant un exemple de réalisation, et dans lesquelles :

- la figure 1 est un schéma général d'un émetteur selon l'invention,
- la figure 2 est un diagramme illustrant un exemple de constellation dans le plan complexe correspondant à une modulation d'amplitude à 16 états,
- la figure 3 est un diagramme illustrant les variations des courbes de puissance de sortie et de rendement ajouté selon la tension de polarisation de drain VD d'un transistor de puissance à effet de champ monté en source commune,
- la figure 4 est un schéma d'un exemple de réalisation d'un émetteur selon l'invention.

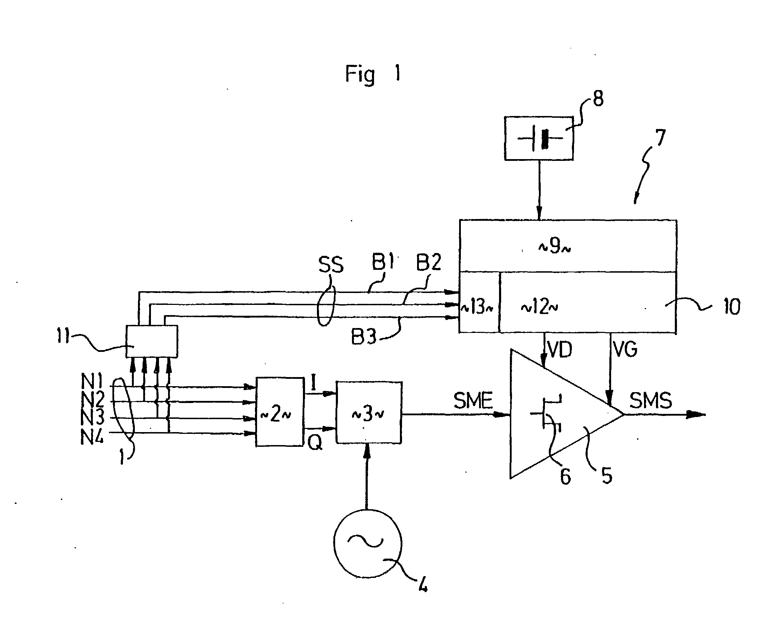

L'émetteur selon l'invention schématiquement représenté figure 1 reçoit des données numériques, dites signaux de commande numériques 1, à émettre, qui, dans l'exemple représenté comprennent quatre bits N1, N2, N3, N4. Les signaux de commande numériques 1 sont fournis à un convertisseur numérique/analogique 2 qui délivre deux signaux analogiques I, Q en quadrature, qui, à leur tour, sont fournis à un circuit modulateur 3 dont la sortie délivre des signaux, dits signaux modulés d'entrée SME modulés sur une porteuse délivrée par un oscillateur 4 au circuit modulateur 3. Les signaux modulés d'entrée SME sont fournis à un amplificateur de puissance 5 comprenant au moins un transistor de puissance 6, dont au moins un transistor de puissance de sortie qui délivre des signaux modulés de sortie SMS fournis à une antenne d'émission (non représentée).

Chaque transistor de puissance 6 des moyens d'amplification 5 est polarisé par des moyens 7 de polarisation fournissant les tensions de polarisation VD de drain et VG de grille des transistors de puissance 6 à effet de champ. Ces moyens 7 de polarisation comprennent une source de tension continue 8, qui est par exemple la barre non régulée à bord d'un satellite, ou une batterie d'accumulateurs ou de piles, des moyens 9 convertisseurs à découpage PWM adaptés pour pouvoir délivrer une pluralité discrète prédéterminée de niveaux de tension de polarisation distincts pour la tension de polarisation de drain et/ou pour la tension de polarisation de grille, et des moyens 10 de commutation adaptés pour appliquer à chaque instant sur chacune des bornes à polariser une tension de polarisation issue des moyens 9 convertisseurs. Un circuit 11 d'analyse logique recueille les signaux de commande numériques 1, et est adapté pour élaborer en temps réel, à partir de la valeur instantanée des signaux de commande numériques, un signal de sélection SS dont la valeur instantanée est représentative du niveau d'amplitude instantané devant être pris par les signaux modulés de sortie SMS à émettre correspondant à cette valeur instantanée des signaux de commande numériques 1.

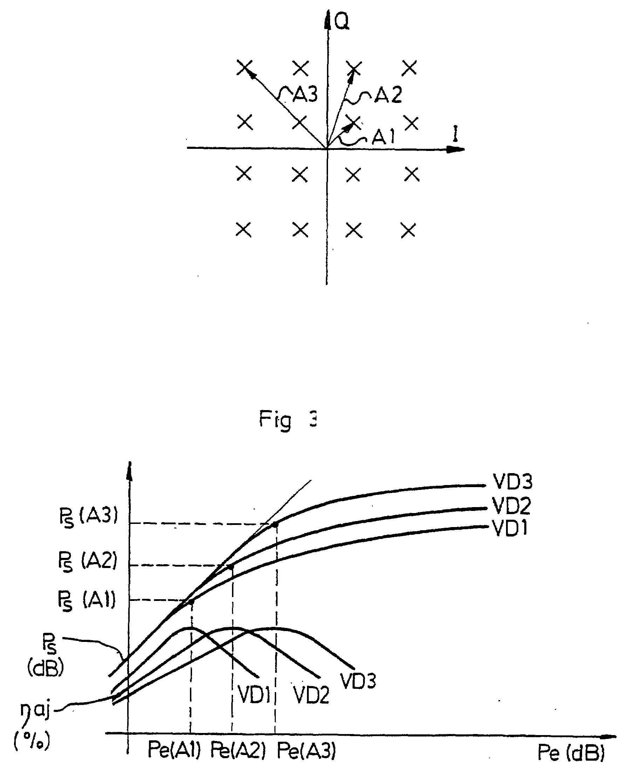

Dans l'exemple de la figure 2, le circuit modulateur 3 est un modulateur, dit 16 QAM, réalisant une modulation d'amplitude à 16 états. Comme on le voit sur la figure 2, l'amplitude du signal peut en fait prendre trois valeurs distinctes A1, A2, A3. Ainsi; selon la valeur prise par les 4 bits N1, N2, N3, N4 des signaux de commande numériques 1, et selon la valeur des signaux I et Q issus du convertisseur 2, on peut déterminer par voie logique quel sera le niveau d'amplitude A1, A2, A3 qui devra être pris par les signaux modulés de sortie SMS. Ce calcul de logique combinatoire est réalisé par le circuit logique d'analyse 11 qui délivre un signal de sélection SS formé de 3 bits de commande B1, B2, B3 correspondant respectivement à chacun des niveaux d'amplitude A1, A2, A3. A chaque instant, un seul des bits de commande B1, B2, B3 est égal à 1, de sorte que le signal de sélection SS est représentatif du niveau d'amplitude A1, A2, A3 des signaux modulés de sortie SMS. Ce signal de sélection SS est fourni aux moyens 10 de commutation.

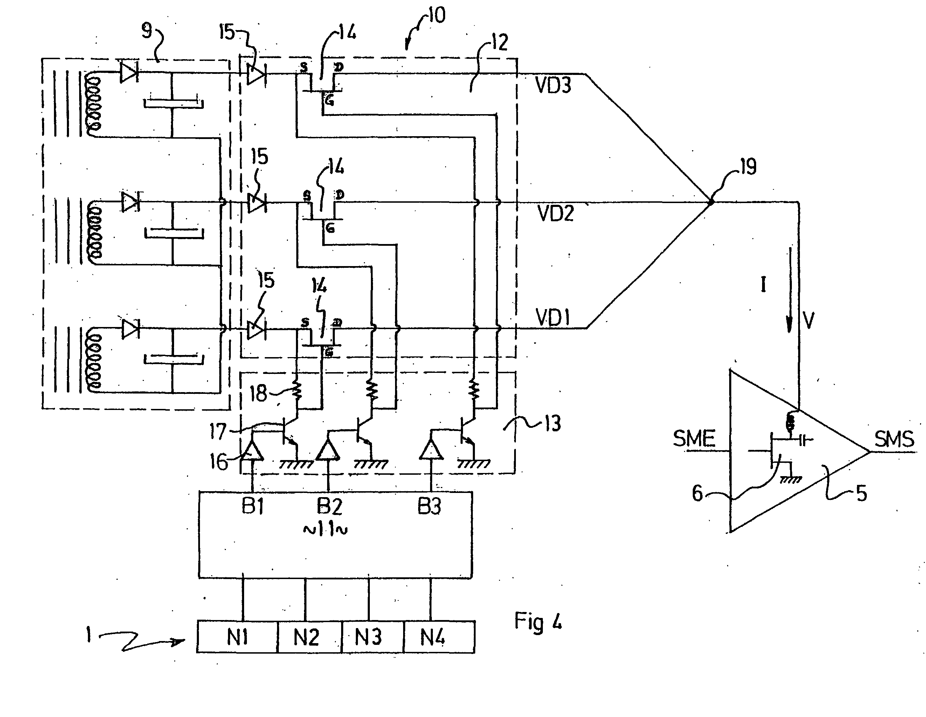

La figure 4 représente plus en détail le circuit permettant de délivrer la tension de polarisation de drain VD aux moyens 5 d'amplification. Les moyens 9 convertisseurs sont adaptés pour fournir trois tensions de polarisation de drain distinctes VD1, VD2, VD3, régulés par les moyens convertisseurs, et correspondant respectivement aux niveaux d'amplitude A1, A2, A3 des signaux modulés de sortie SMS. La valeur de ces tensions de polarisation peut être déterminée pour adapter le fonctionnement du transistor de puissance 6 afin que ce dernier présente le meilleur rendement, selon la puissance d'entrée Pe qu'il reçoit sur sa grille. Dans ce mode de réalisation, les signaux modulés d'entrée sont modulés en amplitude par le circuit modulateur 3 et présentent donc également trois niveaux d'amplitude distincts correspondant aux trois niveaux d'amplitude A1, A2, A3 des signaux modulés de sortie SMS.

On a représenté figure 3 les différentes courbes représentatives de la puissance de sortie Ps en fonction de la puissance d'entrée Pe d'un transistor de puissance de sortie à effet de champ, selon les différentes tensions de polarisation VD1, VD2, VD3. A partir d'une certaine valeur de la puissance d'entrée, le transistor de puissance présente un phénomène de saturation. On a également représenté figure 3 les courbes illustrant les variations du rendement ajouté ηaj du transistor de puissance en fonction de la puissance d'entrée Pe. Comme on le voit, lorsque la tension de polarisation de drain VD varie, le rendement ajouté ηaj ne varie pas en valeur maximum, mais se décale, le maximum de son rendement étant toujours situé au voisinage du début de saturation du transistor. Le rendement ajouté ηaj du transistor, qui est le critère de rendement utilisé dans le domaine des hyperfréquences est donné par la formule : $\eta aj = \frac{Ps-Pe}{Palim}$, où Palim représente la puissance d'alimentation sur le drain, c'est-à-dire est égale au produit de la tension de polarisation de drain VD multipliée par le courant ID correspondant. Ainsi, on choisit la tension de polarisation VD3 (de plus grande valeur) pour que la puissance de sortie Ps (A3) correspondant au niveau d'amplitude A3 le plus élevé prenne la valeur de la puissance de sortie de début de saturation, le rendement ajouté étant alors maximum. De même, la tension de polarisation VD2 est adaptée pour que la puissance de sortie Ps (A2) correspondante soit située au point de début de saturation, le rendement ajouté pour cette tension de polarisation VD étant à son maximum. Et on fait de même pour la tension VD1 pour laquelle la puissance de sortie Ps (A1) du niveau d'amplitude le plus bas est située à la valeur limite de saturation, le rendement ajouté étant encore à sa valeur maximum.

Ces différentes valeurs VD1, VD2, VD3 peuvent être obtenues soit à partir d'un seul convertisseur de tension ayant un enroulement primaire et plusieurs enroulements secondaires délivrant les différentes valeurs VD1, VD2, VD3, soit, de préférence, à partir de trois convertisseurs distincts fournissant, à partir de la source de tension 8, les trois valeurs VD1, VD2, VD3.

Les moyens 10 de commutation comprennent un circuit de commutation 12 recevant les différentes valeurs de tension VD1, VD2, VD3 issues des convertisseurs 9, ainsi que le signal de sélection SS par l'intermédiaire d'un circuit d'adaptation 13 qui permet de commander en commutation trois transistors à effet de champ 14 utilisés en commutateurs du circuit de commutation 12. Ces trois transistors 14 sont des transistors MOSFET recevant sur leur source la tension issue du convertisseur 9 par l'intermédiaire d'une diode anti-retour 15. Le circuit d'adaptation 13 reçoit les trois signaux numériques B1, B2, B3 du signal de sélection SS et comprend, pour chacun d'eux, un amplificateur 16 alimentant la base d'un transistor bipolaire 17 dont l'émetteur est relié à la masse et le collecteur est relié à la grille du transistor MOSFET 14 correspondant, et, par l'intermédiaire d'une résistance 18, entre la source du transistor MOSFET 14 et la diode 15. De la sorte, lorsque le bit B1 est égal à 1, le transistor de commutation 14 correspondant est à l'état passant et le circuit de commutation fournit la tension VD1. Les bits B2 et B3 étant égaux tous les deux à zéro, les deux autres transistors 14 sont à l'état bloqué. Les trois drains des transistors 14 étant reliés à un noeud commun en sortie 19, ce noeud 19 reçoit uniquement l'une des tensions de polarisation VD1, VD2, VD3, et ce en fonction de la valeur des bits B1, B2, B3 du signal de sélection SS, elle-même déterminée pour être représentative du niveau d'amplitude A1, A2, A3 des signaux modulés de sortie SMS. Les moyens 10 de commutation sélectionnent donc et appliquent au noeud 19 le niveau de tension de polarisation de drain optimum pour le transistor de puissance de sortie 6. Dans ces conditions, on comprend que le rendement ajouté ηaj du transistor de puissance 6 est toujours optimum.

Il est à noter que les moyens 10 de commutation et les moyens 9 convertisseurs, ainsi d'ailleurs que le circuit 11 d'analyse logique, sont des circuits extrêmement simples qui ne véhiculent en aucune manière les signaux à haute fréquence.

L'invention peut faire l'objet de diverses variantes par rapport au mode de réalisation décrit ci-dessus et représenté sur les figures. En particulier, la tension de polarisation de grille VG peut être également pilotée, de façon semblable, de telle sorte que les signaux modulés de sortie SMS n'aient pas leur amplitude modifiée selon les variations de la tension de polarisation de drain VD. Ce résultat peut aussi être obtenu au moins en partie en choisissant une classe de fonctionnement appropriée du transistor de puissance de sortie 6, par exemple la classe B.

A l'inverse, il est aussi possible de prévoir que le circuit modulateur 3 ne soit pas un circuit modulateur d'amplitude, c'est-à-dire ne réalise qu'une modulation de phase de type PSK, de sorte que les signaux modulés d'entrée SME présentent toujours au moins sensiblement le même niveau d'amplitude. La modulation d'amplitude peut alors être réalisée par les moyens 5 d'amplification en choisissant des valeurs appropriées des différents niveaux de tension de polarisation VD délivrée au noeud 19 pour les transistors de puissance 6. En effet, les différents niveaux de tension de polarisation de drain varient comme les signaux de commande numériques 1 et comme le niveau d'amplitude correspondant pour les signaux modulés de sortie SMS. Dans ce cas, les moyens de modulation sont donc pour partie formés des moyens 5 d'amplification, et des moyens 11 d'analyse et 10 de commutation.

En outre, l'invention est applicable à d'autres types de modulation que la modulation 16-QAM, et en particulier avec une modulation ayant un nombre d'états plus grand (32-QAM, 64-QAM...).

Dans une autre variante, il est possible de fournir un nombre de niveaux de tension de polarisation de drain inférieur au nombre de niveaux d'amplitude des signaux modulés de sortie, par exemple lorsque ces différents niveaux d'amplitude peuvent être regroupés par niveaux proches, ou lorsque l'on admet, pour certains niveaux d'amplitude, que la tension de polarisation de drain ne soit pas parfaitement optimale. Par exemple, on pourrait n'utiliser qu'un seul niveau de tension de polarisation pour plusieurs niveaux d'amplitude les plus faibles (en particulier lorsqu'on utilise une modulation ayant un grand nombre d'états).

## Revendications

1. Emetteur de signaux radioélectriques, dits signaux modulés de sortie (SMS), modulés au moins en amplitude selon une pluralité discrète de niveaux d'amplitude distincts prédéterminés (A1, A2, A3), à partir de signaux de commande numériques (1), comprenant :

   - des moyens (3) de modulation adaptés pour convertir les signaux de commande numériques (1) en signaux modulés, dits signaux modulés d'entrée (SME),
   - des moyens (5) d'amplification de puissance à état solide comportant au moins un transistor de puissance, dont au moins un transistor de puissance de sortie (6) délivre des signaux modulés de sortie (SMS),
   - des moyens (7) de polarisation comportant au moins une source de tension, et adaptés pour polariser chaque transistor de puissance des moyens (5) d'amplification,

   **caractérisé en ce que** les moyens (7) de polarisation sont adaptés pour pouvoir délivrer, pour au moins une borne à polariser de chaque transistor de puissance de sortie (6) des moyens (5) d'amplification, une pluralité discrète prédéterminée de niveaux de tension de polarisation distincts (VD1, VD2, VD3), chaque niveau de tension de polarisation étant associé et adapté à l'un au moins desdits niveaux d'amplitude (A1, A2, A3) des signaux modulés de sortie (SMS),
et **en ce qu'**il comprend :

- des moyens, dits moyens (11) d'analyse, adaptés pour élaborer en temps réel à partir de la valeur instantanée des signaux de commande numériques (1), un signal, dit signal de sélection (SS), dont la valeur instantanée est représentative du niveau d'amplitude instantané devant être pris par les signaux modulés de sortie (SMS) à émettre correspondant à cette valeur instantanée des signaux de commande numériques (1), la valeur instantanée du signal de sélection (SS) variant avec les signaux de commande numériques (1) selon une pluralité discrète de valeurs correspondant aux différents niveaux d'amplitude (A1, A2, A3) des signaux modulés de sortie (SMS),
- des moyens (10) de commutation recevant le signal de sélection (SS) et adaptés pour sélectionner et appliquer à chaque instant, sur ladite borne à polariser, une tension de polarisation délivrée par les moyens (7) de polarisation dont la valeur est égale au niveau de tension de polarisation associé et adapté au niveau d'amplitude représenté par la valeur instantanée du signal de sélection (SS).

2. Emetteur selon la revendication 1, **caractérisé en ce que** les moyens (11) d'analyse sont formés d'un circuit électronique logique (11) adapté pour déterminer, à partir de la valeur numérique instantanée des signaux de commande numériques (1), ledit niveau d'amplitude instantané et pour élaborer le signal de sélection (SS) représentatif de ce niveau d'amplitude instantané.

3. Emetteur selon l'une des revendications 1 et 2, comprenant un circuit de modulation (3) adapté pour convertir les signaux de commande numériques (1) en signaux analogiques modulés, au moins en amplitude, selon une pluralité discrète de niveaux d'amplitude distincts prédéterminés, **caractérisé en ce que** les moyens (11) d'analyse sont adaptés pour élaborer et délivrer, à partir des signaux de commande numériques (1), un signal de sélection (SS) dont la valeur instantanée est représentative du niveau d'amplitude instantané des signaux délivrés par le circuit de modulation (3).

4. Emetteur selon l'une des revendications 1 à 3, **caractérisé en ce que** les moyens (3) de modulation sont des moyens de modulation d'amplitude M-QAM en quadrature à M états, M étant une puissance de 2.

5. Emetteur selon l'une des revendications 1 à 4, **ca-**

**ractérisé en ce que** ladite pluralité discrète de niveaux de tension de polarisation comprend un nombre entier N>1 de niveaux de tension de polarisation (VD1, VD2, VD3) égal au nombre de niveaux d'amplitude (A1, A2, A3) de ladite pluralité discrète de niveaux d'amplitude des signaux modulés de sorte (SMS), chaque niveau de tension de polarisation étant associé et adapté à un et un seul niveau d'amplitude.

6. Emetteur selon l'une des revendications 1 à 5, **caractérisé en ce que** chaque niveau de tension de polarisation est adapté pour que le rendement de chaque transistor de puissance de sortie (6) polarisé avec ce niveau de tension de polarisation soit optimum pour le niveau d'amplitude des signaux modulés de sortie (SMS) qu'il délivre.

7. Emetteur selon l'une des revendications 1 à 6, **caractérisé en ce que** chaque niveau de tension de polarisation est adapté pour que chaque transistor de puissance de sortie (6) polarisé avec ce niveau de tension de polarisation délivre une puissance de sortie (Ps) qui est de l'ordre de sa puissance de début de saturation pour le niveau d'amplitude des signaux modulés de sortie (SMS) qu'il délivre.

8. Emetteur selon l'une des revendications 1 à 7, **caractérisé en ce que** chaque transistor de puissance de sortie (6) des moyens (5) d'amplification est un transistor à effet de champ recevant des signaux modulés d'entrée (SME) sur sa grille et délivrant les signaux modulés de sortie (SMS) sur son drain, **en ce que** les moyens (7) de polarisation sont adaptés pour pouvoir délivrer une pluralité discrète de niveaux de tension VD de polarisation du drain, et **en ce que** les moyens (10) de commutation sont adaptés pour piloter la valeur de la tension VD de polarisation du drain de chaque transistor de puissance de sortie (6) selon la valeur du signal de sélection (SS).

9. Emetteur selon l'une des revendications 1 à 8, **caractérisé en ce que** chaque transistor de puissance de sortie (6) des moyens (5) d'amplification est un transistor à effet de champ recevant des signaux modulés d'entrée (SME) sur sa grille et délivrant les signaux modulés de sortie (SMS) sur son drain, **en ce que** les moyens (7) de polarisation sont adaptés pour pouvoir délivrer une pluralité discrète de niveaux de tension VG de polarisation de la grille, et **en ce que** les moyens (10) de commutation sont adaptés pour piloter la valeur de la tension VG de polarisation de la grille de chaque transistor de puissance de sortie (6) selon la valeur du signal de sélection (SS).

10. Emetteur selon l'une des revendications 1 à 9, **ca-**

**ractérisé en ce qu'**il est adapté pour l'émission de signaux avec une porteuse dans le domaine des hyperfréquences, et aptes à transmettre des données numériques avec un débit compris entre 1 Mbits/s et 100 Mbits/s.

## Claims

1. A transmitter of radio signals, referred to as output modulated signals (SMS), which are modulated at least in amplitude according to a discrete plurality of predetermined separate amplitude levels (A1, A2, A3), on the basis of digital control signals (1) comprising,

   - modulation means (3) adapted to convert the digital control signals (1) into modulated signals, referred to as input modulated signals (SME),
   - solid-state power amplification means (5) including at least one power transistor, of which at least one output power transistor (6) delivers output modulated signals (SMS),
   - bias means (7) including at least one voltage source, and adapted to bias each power transistor of the amplification means (5),

   **characterized in that** the bias means (7) are adapted to be able to deliver, for at least one terminal to be biased in each output power transistor (6) of the amplification means (5), a predetermined discrete plurality of separate bias-voltage levels (VD1, VD2, VD3), each bias-voltage level being associated with and adapted to at least one of said amplitude levels (A1, A2, A3) of the output modulated signals (SMS), which transmitter also comprises:

   - means, referred to as analysis means (11), adapted to generate in real time, on the basis of the instantaneous value of the digital control signals (1), a signal, referred to as a selection signal (SS), whose instantaneous value is representative of the instantaneous amplitude level needing to be taken by the output modulated signals (SMS) to be transmitted corresponding to this instantaneous value of the digital control signals (1), the instantaneous value of the selection signal (SS) varying with the digital control signals (1) according to a discrete plurality of values corresponding to the various amplitude levels (A1, A2, A3) of the output modulated signals (SMS),
   - switch means (10) receiving the selection signal (SS), and adapted to select and apply at each instant, to said terminal to be biased, a bias voltage that is delivered by the bias means (7) and whose value is equal to the bias-voltage level associated with and adapted to the amplitude level represented by the instantaneous value of the selection signal (SS).

2. Transmitter according to claim 1, **characterized in that** the analysis means (11) are formed by an electronic logic circuit (11) adapted to determine said instantaneous amplitude level, on the basis of the instantaneous digital value of the digital control signals (1), and to generate the selection signal (SS) representative of this instantaneous amplitude level.

3. Transmitter according to one of claims 1 and 2, comprising a modulation circuit (3) adapted to convert the digital control signals (1) into analog signals that are modulated, at least in amplitude, according to a discrete plurality of predetermined separate amplitude levels, **characterized in that** the analysis means (11) are adapted to generate and deliver, on the basis of the digital control signals (1), a selection signal (SS) whose instantaneous value is representative of an instantaneous amplitude level of the signals delivered by the modulation circuit (3).

4. Transmitter according to one of claims 1 to 3, **characterized in that** the modulation means (3) are means for quadrature amplitude modulation M-QAM with M states, M being a power of 2.

5. Transmitter according to one of claims 1 to 4, **characterized in that** said discrete plurality of bias-voltage levels comprises an integer number N>1 of bias-voltage levels (VD1, VD2, VD3) equal to the number of amplitude levels (A1, A2, A3) of said discrete plurality of amplitude levels of the output modulated signals (SMS), each bias-voltage level being associated with and adapted to one and only one amplitude level.

6. Transmitter according to one of claims 1 to 5, **characterized in that** each bias-voltage level is adapted so that the efficiency of each output power transistor (6), biased with this bias-voltage level, is optimal for the amplitude level of the output modulated signals (SMS) that it delivers.

7. Transmitter according to one of claims 1 to 6, **characterized in that** each bias-voltage level is adapted so that each output power transistor (6), biased with this bias-voltage level, delivers an output power (Ps) which is of the order of its saturation-onset power for the level of the output modulated signals (SMS) that it delivers.

8. Transmitter according to one of claims 1 to 7, **characterized in that** each output power transistor (6) of the amplification means (5) is a field-effect transistor receiving input modulated signals (SME) on its gate and delivering the output modulated signals (SMS) on its drain, **characterized in that** the bias means (7) are adapted to be able to deliver a discrete plurality of drain bias-voltage levels VD, and **in that** the switch means (10) are adapted to drive the value of the drain bias voltage VD of each output power transistor (6) according to the value of the selection signal (SS).

9. Transmitter according to one of claims 1 to 8, **characterized in that** each output power transistor (6) of the amplification means (5) is a field-effect transistor receiving input modulated signals (SME) on its gate and delivering the output modulated signals (SMS) on its drain, **characterized in that** the bias means (7) are adapted to be able to deliver a discrete plurality of gate bias-voltage levels VG, and **in that** the switch means (10) are adapted to drive the value of the gate bias voltage VG of each output power transistor (6) according to the value of the selection signal (SS).

10. Transmitter according to one of claims 1 to 9, **characterized in that** it is adapted for the transmission of signals that have a carrier in the microwave range and are capable of transmitting digital data with a rate of between 1 Mbit/s and 100 Mbit/s.

**Patentansprüche**

1. Sender für Funksignale, modulierte Ausgangssinale (SMS) genannt, die wenigstens amplitudenmäßig gemäß einer diskreten Mehrzahl von vorbestimmten unterschiedlichen Amplitudengrößen (A1, A2, A3) auf der Basis von numerischen Steuersignalen (1) moduliert sind, wobei der Sender Folgendes umfasst:

   - Modulationsmittel (3) zum Konvertieren der numerischen Steuersignale (1) in modulierte Signale, modulierte Eingangssignale (SME) genannt,
   - Halbleiter-Leistungsverstärkungsmittel (5) mit wenigstens einem Leistungstransistor, von denen wenigstens ein Ausgangsleistungstransistor (6) modulierte Ausgangssignale (SMS) ausgibt,
   - Polarisationsmittel (7), die wenigstens eine Spannungsquelle umfassen und die Aufgabe haben, für jeden Leistungstransistor Verstärkungsmittel (5) zu polarisieren,

   **dadurch gekennzeichnet, dass** die Polarisationsmittel (7) so gestaltet sind, dass sie für wenigstens einen zu polarisierenden Anschluss jedes Ausgangsleistungstransistors (6) der Verstärkungsmittel (5) eine vorbestimmte diskrete Mehrzahl von unterschiedlichen Polarisationsspannungspegeln (VD1, VD2, VD3) erzeugen, wobei jeder Polarisationsspannungspegel mit einem von wenigstens den genannten Amplitudengrößen (A1, A2, A3) der modulierten Ausgangssignale (SMS) assoziiert und daran angepasst ist,
und dadurch, dass er Folgendes umfasst:

   - Mittel, Analysemittel (11) genannt, deren Aufgabe es ist, in Echtzeit auf der Basis des Momentanwertes von numerischen Steuersignalen (1) ein Signal, Auswahlsignal (SS) genannt, zu erzeugen, dessen Momentanwert für die momentane Amplitudengröße repräsentativ ist, die die zu sendenden modulierten Ausgangssignale (SMS) einnehmen sollen und die diesem Momentanwert der numerischen Steuersignale (1) entsprechen, wobei der Momentanwert des Auswahlsignals (SS) mit den numerischen Steuersignalen (1) gemäß einer diskreten Mehrzahl von Werten variieren, die anderen Amplitudengrößen (A1, A2, A3) der modulierten Ausgangssignale (SMS) entsprechen,
   - Kommutationsmittel (10), die das Auswahlsignal (SS) empfangen und die Aufgabe haben, in jedem Augenblick an den genannten zu polarisierenden Anschluss eine Polarisationsspannung anzulegen, die von den Polarisationsmitteln (7) ausgegeben wird, deren Wert gleich dem Polarisationsspannungspegel ist, der mit der Amplitudengröße assoziiert und an diese angepasst ist, die durch den Momentanwert des Auswahlsignals (SS) repräsentiert wird.

2. Sender nach Anspruch 1, **dadurch gekennzeichnet, dass** die Analysemittel (11) von einer elektronischen Logikschaltung (11) gebildet werden, deren Aufgabe es ist, auf der Basis des numerischen Momentanwertes der numerischen Steuersignale (1) die genannte momentane Amplitudengröße zu bestimmen und das Auswahlsignal (SS) zu erzeugen, das für die momentane Amplitudengröße repräsentativ ist.

3. Sender nach Anspruch 1 und 2, umfassend eine Modulationsschaltung (3) zum Konvertieren der numerischen Steuersignale (1) in analoge Signale, die wenigstens amplitudenmäßig gemäß einer diskreten Mehrzahl von vorbestimmten unterschiedlichen Amplitudengrößen moduliert wurden,
**dadurch gekennzeichnet, dass** die Analysemittel (11) die Aufgabe haben, auf der Basis der numerischen Steuersignale (1) ein Auswahlsignal (SS) zu erzeugen und auszugeben, dessen Momentanwert-für die momentane Amplitudengröße der Signale repräsentativ sind, die von der Modulationsschaltüng (3) ausgegeben werden.

4. Sender nach einem der Ansprüche 1 bis 3, **dadurch gekennzeichnet, dass** die Modulationsmittel (3) Quadraturamplitudenmodulationsmittel M-QAN mit M Zuständen sind, wobei M eine Zweierpotenz ist.

5. Sender nach einem der Ansprüche 1 bis 4, **dadurch gekennzeichnet, dass** die genannte diskrete Mehrzahl von Polarisationsspannungspegeln eine ganze Zahl N>1 von Polarisationspannungspegeln (VD1, VD2, VD3) umfasst, die gleich der Zahl der Amplitudengrößen (A1, A2; A3) der genannten diskreten Mehrzahl von Amplitudengrößen der modulierten Ausgangssignale (SMS) ist, wobei jeder Polarisationsspannungspegel mit nur einem einzigen Amplitudenniveau assoziiert und daran angepasst ist.

6. Sender nach einem der Ansprüche 1 bis 5, **dadurch gekennzeichnet, dass** jeder Polarisationsspannungspegel so gewählt wird, dass der Wirkungsgrad jedes Ausgangsleistungstransistors (6), der mit diesem Polarisationsspannungspegel polarisiert ist, für die Amplitudengröße der modulierten Ausgangssignale (SMS) optimal ist, das.er ausgibt.

7. Sender nach einem der Ansprüche 1 bis 6, **dadurch gekennzeichnet, dass** jeder Polarisationsspannungspegel so gewählt wird, dass jeder Ausgangsleistungstransistor (6), der mit diesem Polarisationsspannungspegel polarisiert ist, eine Ausgangsleistung (Ps) ausgibt, die von der Größenordnung seiner Sättigungsanfangsleistung für die Amplitudengröße der modulierten Ausgangssignale (SMS) ist, die er ausgibt.

8. Sender nach einem der Ansprüche 1 bis 7, **dadurch gekennzeichnet, dass** jeder Ausgangsleistungstransistor (6) der Verstärkungsmittel (5) ein Feldeffekttransistor ist, der an seinem Gate die modulierten Eingangssignale (SME) empfängt und diese modulierten Ausgangssignale (SMS) an seinen Drain anlegt, dadurch, dass die Polarisationsmittel (7) so gestaltet sind, dass sie eine diskrete Mehrzahl von Polarisationsspannungspegeln VD des Drains anlegen können, und dadurch, dass die Kommutationsmittel (10) die Aufgabe haben, den Wert der Polarisationsspannung VD des Drains jedes Ausgangsleistungstransistors (6) gemäß dem Wert des Auswahlsignals (SS) zu steuern.

9. Sender nach einem der Ansprüche 1 bis 8, **dadurch gekennzeichnet, dass** jeder Ausgangsleistungstransistor (6) der Verstärkungsmittel (5) ein Feldeffekttransistor ist, der an seinem Gate die modulierten Eingangssignale (SME) empfängt und die modulierten Ausgangssignale (SMS) an seinen Drain anlegt, dadurch, dass die Polarisationsmittel (7) so gestaltet sind, dass sie eine diskrete Mehrzahl von Polarisationsspannungspegeln VG des Gate ausgeben, und dadurch, dass die Kommutationsmittel (10) die Aufgabe haben, den Wert der Polarisationsspannung VG des Gate jedes Ausgangsleistungstransistors (6) gemäß dem Wert des Auswahlsignals (SS) zu steuern.

10. Sender nach einem der Ansprüche 1 bis 9, **dadurch gekennzeichnet, dass** er die Aufgabe hat, Signale mit einem Träger in der Höchstfrequenzdomäne zu senden, und die Fähigkeit hat, numerische Daten mit einer Bitrate zwischen 1 Mbit/s und 100 Mbit/s zu übertragen.

Fig 1

Fig 3

Fig 4